# FASCICULE DE BREVET EUROPEEN

(11) **EP 2 164 157 B1**
(45) Date de publication et mention de la délivrance du brevet: **14.12.2011**
(21) Numéro de dépôt: 09305848.5
(22) Date de dépôt: 15.09.2009
(51) Int. Cl.: H02M 1/088, H03K 17/10

(54) **Circuit de commande d'un transistor IGBT, et circuit de communication électronique comprenant un transistor IGBT et un tel circuit de commande**
Ansteuerschaltung für einen IGBT Transistor, und elektronische Kommunikationsschaltung mit einem IGBT Transistor, und eine solche Ansteuerschaltung
Control circuit for an IGBT transistor, and an electronic communication circuit comprising such a control circuit

(30) Priorité: 15.09.2008 FR 0856183
(43) Date de publication de la demande: 17.03.2010
(73) Titulaire: Converteam Technology Ltd, Rugby Warwickshire CV21 1BU (GB)
(72) Inventeur: Gollentz, Bernard, 68360 Soultz (FR); Conilh, Christophe, 90360 La Chapelle sous Rougemont (FR); Duchêne, Sébastien, 70300 Luxeuil les Bains (FR)
(74) Mandataire: Jacobson, Claude

(56) Documents cités:
- EP-A- 0 902 537
- EP-A- 0 926 826
- US-A- 5 949 273
- US-A1- 2008 106 319
- US-B1- 6 320 362
- EANNIN PIERRE-OLIVIER ET AL: "Le transistor MOSFET en commutation : Application aux associations série et parallèle de composants à grille isolée = Study of MOSFET switching behavior : application to series and parallel association of insulated gate components" THESIS,, 29 mai 2001 (2001-05-29), page 148PP, XP009113737

## Description

La présente invention concerne un circuit de commande d'un transistor IGBT propre à être connecté en série avec au moins un autre transistor IGBT.

Il est connu d'assurer la redondance des transistors IGBT dans les ponts onduleurs, de manière à assurer la continuité de fonctionnement de l'onduleur même si l'un des IGBTs dont il est constitué venait à casser. Elle exploite une des particularités de l'IGBT lorsqu'il est cassé : le fait qu'il se retrouve en court-circuit. Cette redondance est assurée, par exemple, en disposant deux IGBTs en série là où habituellement un seul IGBT suffirait. La casse d'un des deux IGBTs n'empêche pas la continuité de fonctionnement du pont.

Cependant, la mise en série d'IGBTs ne peut se faire sans l'aide de circuits auxiliaires assurant une répartition équivalente de la tension aux bornes de chaque IGBT. De plus, pour pouvoir assurer la redondance d'IGBT, le système d'équilibrage utilisé doit être propre à chaque IGBT de manière que la casse d'un IGBT n'entraîne pas un déséquilibre de tension sur les IGBTs sains restants.

On connaît par le document WO2007122322 un procédé d'équilibrage des tensions de deux IGBTs en série utilisant une méthode dite "d'active sharing" (notion de maître esclave).

Cette méthode n'est pas totalement satisfaisante dans la mesure où elle est basée sur une notion de maître esclave, c'est à dire que la vitesse de commutation de l'IGBT esclave est asservie sur la vitesse de commutation de l'IGBT maître. Le résultat de l'équilibrage est dépendant de chaque IGBT. Si l'un des IGBTs casse, l'asservissement ne peut plus être réalisé et l'équilibrage des tensions des IGBTs ne se fera pas correctement.

On a également proposé l'utilisation d'une capacité extérieure entre grille et collecteur de l'IGBT, qui permet l'équilibrage des tensions ("dv/dt controller") dans le document Pierre-Olivier JEANNIN "Le transistor MOSFET en commutation : Application aux associations série et parallèle de composants à grille isolée", Thèse de doctorat, Institut National Polytechnique de Grenoble. Cette capacité ajoutée permet de réduire les différences relatives entre composants. Cette solution permet aussi bien de compenser des différences de dv/dt dues au composant lui même qu'à des temps de retard dus aux imperfections des circuits de commande.

L'inconvénient de cette solution vient du fait que l'ajout de cette capacité extérieure diminue la pente de la tension collecteur émetteur de l'IGBT. Cette diminution de pente a pour conséquence d'allonger la durée de commutation des IGBTs et donc d'augmenter les pertes par commutation de ces derniers. Par contre si un IGBT casse, l'équilibrage peut encore être garanti. De plus, le contrôleur de dv/dt est actif à la fermeture du composant (d'où résultent des pertes supplémentaires) bien que la maîtrise de l'équilibrage des tensions pendant une fermeture (turn-on) soit beaucoup moins critique que lors d'une ouverture (turn-off).

La présente invention vise à palier ces inconvénients.

A cet effet, l'invention a tout d'abord pour objet un circuit de commande d'un transistor IGBT, le transistor IGBT étant propre à être connecté en série avec au moins un autre transistor IGBT, la grille du transistor IGBT étant propre à être reliée à un circuit de commande de fermeture par l'intermédiaire d'une résistance de fermeture et à un circuit de commande d'ouverture par l'intermédiaire d'une résistance d'ouverture, le circuit comprenant un condensateur relié au collecteur et à la grille du transistor IGBT, et une diode connectée en série avec le condensateur, caractérisé en ce qu'il comprend en outre deux diodes Zener connectées tête-bêche entre l'émetteur du transistor IGBT et le point commun au condensateur et à la diode, et en ce que la diode est connectée en série entre le condensateur et la grille du transistor IGBT.

Les diodes zener permettent de décharger le condensateur.

Suivant d'autres modes de réalisation, le circuit de commande comprend une ou plusieurs des caractéristiques, prises isolément ou suivant toutes les combinaisons techniquement possibles :
- la diode est connectée dans le sens passant du collecteur à la grille,
- le circuit de commande comprend une résistance est connectée en série avec ledit condensateur et ladite diode, et
- la valeur de la capacité du condensateur est sensiblement égale à 6,6 nF.

La diode, du fait de sa position, évite que le condensateur ne modifie la pente de la tension collecteur émetteur lors de la fermeture de l'IGBT.

La résistance sert à amortir les oscillations dues à la présence du condensateur et des inductances parasites.

L'invention a également pour objet un circuit de commutation électronique comprenant un transistor IGBT propre à être connecté en série avec un transistor IGBT d'au moins un autre circuit de commutation, le circuit de commutation comprenant un circuit de commande de fermeture relié à la grille du transistor IGBT par l'intermédiaire d'une résistance de fermeture, un circuit de commande d'ouverture relié à ladite grille par l'intermédiaire d'une résistance d'ouverture, et un circuit de commande du transistor IGBT, caractérisé en ce que le circuit de commande est tel que défini ci-dessus.

Suivant d'autres modes de réalisation, le circuit de commutation électronique comprend une ou plusieurs des caractéristiques, prises isolément ou suivant toutes les combinaisons techniquement possibles :
- la valeur de la résistance d'ouverture est choisie de sorte qu'un délai d'ouverture du transistor IGBT lors de sa commutation soit inférieur à 3 µs, et
- la valeur de la résistance d'ouverture est sensiblement égale à 1 ohm.

L'invention a également pour objet un équipement électronique de puissance comprenant une pluralité de circuits de commutation électronique, caractérisé en ce que chaque circuit de commutation est tel que défini ci-dessus, et en ce que les transistors IGBT de chacun des circuits de commutation sont connectés en série.

La valeur de la résistance d'ouverture est ainsi réduite de sorte qu'un délai d'ouverture du transistor IGBT lors de sa commutation soit inférieur à 3 µs.

Par valeur "réduite", on entend une valeur inférieure à celle qui serait normalement adoptée dans un montage classique, en l'absence du condensateur reliant le collecteur à la grille de l'IGBT.

On sait que le délai d'ouverture d'un IGBT est lié à la valeur de la résistance d'ouverture Rg_off reliée à la grille de l'IGBT. Plus cette valeur est petite et plus ce temps est petit. A titre d'exemple, la valeur typique pour les IGBTs utilisés actuellement est de l'ordre de 7,5 µs. Mais cette valeur peut varier de + ou - 10 % (liée à l'IGBT). Ce qui peut entraîner des instants de début de commutation différents entre les IGBTS connectés en série et par conséquent un important déséquilibre des tensions.

En réduisant la valeur de la résistance d'ouverture et donc le délai d'ouverture de chaque IGBT, on réduit ainsi l'écart entre les instants de début de commutation des IGBTs connectés en série, et l'équilibrage des tensions obtenu sera correct. Cependant, la modification de la résistance d'ouverture Rg_off modifie la pente de la tension collecteur émetteur de l'IGBT lors de l'ouverture. Afin de garder cette pente à une valeur identique à celle obtenue avec une valeur « classique » de résistance d'ouverture, un condensateur est ajouté entre la grille et le collecteur de l'IGBT.

L'équipement électronique de puissance comporte une pluralité de transistors IGBT connectés en série, dans lequel lesdits IGBT sont chacun associés à un circuit de commutation tel que décrit ci-dessus.

L'invention présente l'avantage d'être propre à chaque IGBT. Chaque IGBT connecté en série est équipé de ce circuit. La casse d'un IGBT ne remet pas en cause l'équilibrage des tensions aux bornes des IGBTs sains restants.

Avec un réglage approprié des valeurs de la résistance d'ouverture et du condensateur, la pente de la tension collecteur émetteur de l'IGBT lors de l'ouverture n'est pas modifiée, ce qui n'induit aucune perte supplémentaire. Au cours de la fermeture, le circuit n'est pas activé.

On décrira maintenant, à titre d'exemple non limitatif, un mode de réalisation particulier de l'invention, en référence aux dessins schématiques annexés dans lesquels :
- la figure 1 est un schéma électrique d'un circuit selon l'invention ;
- les figures 2 et 3 illustrent l'évolution des tensions et intensité lors de l'ouverture de l'IGBT, respectivement avec et sans le circuit de l'invention ;
- les figures 4 et 5 illustrent la tension collecteur émetteur de l'IGBT lors de la fermeture, respectivement avec et sans le circuit de l'invention ; et
- la figure 6 illustre l'évolution des tensions et intensité de trois IGBTs en série lors d'une ouverture avec le circuit de l'invention.

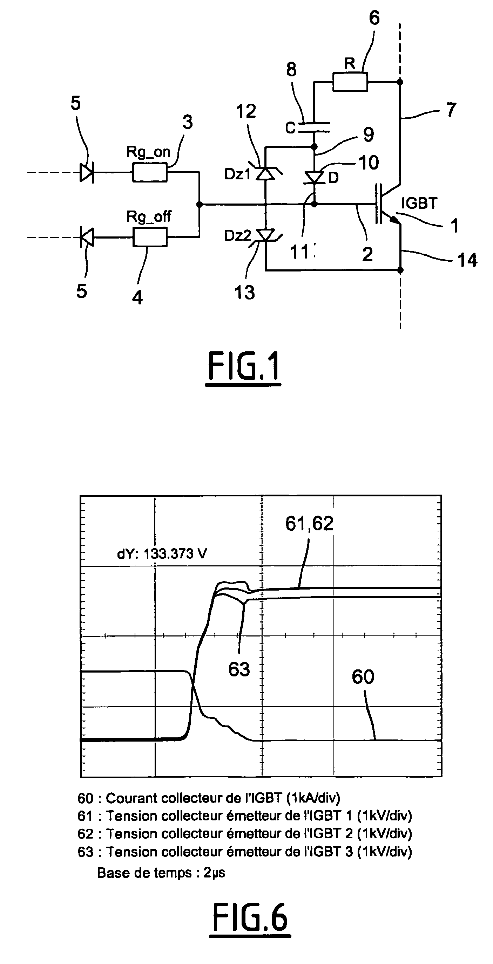

Comme montré sur la figure 1, un transistor IGBT 1 est connecté en série avec d'autres IGBTs (non représentés). La grille 2 de l'IGBT est reliée de façon connue à deux circuits de commande de fermeture et d'ouverture, respectivement par l'intermédiaire de deux résistances Rg_on 3 et Rg_off 4 et de deux diodes 5 disposée dans le sens convenable.

Une résistance 6 a une de ses bornes reliée au collecteur 7 de l'IGBT et l'autre à une borne d'un condensateur 8. L'autre borne du condensateur 8 est reliée à l'anode 9 d'une diode 10 dont la cathode 11 est connectée à la grille 2 de l'IGBT.

Deux diodes zener 12 et 13 sont montées tête-bêche entre le point commun au condensateur 8 et à l'anode 11 de la diode 10, et l'émetteur 14 de l'IGBT. Les diodes zener 12 et 13 ont leurs anodes communes et leurs cathodes reliées respectivement au condensateur et à l'émetteur de l'IGBT.

La valeur de la résistance Rg_off 4 est choisie faible pour réduire le délai d'ouverture de l'IGBT, mais suffisante de manière à ne pas obtenir un courant de grille trop important. La valeur du condensateur est, elle, choisie en fonction de la valeur de la résistance Rg_off retenue. Elle permet de fixer à la valeur désirée le dv/dt de la tension collecteur émetteur de l'IGBT lors de l'ouverture.

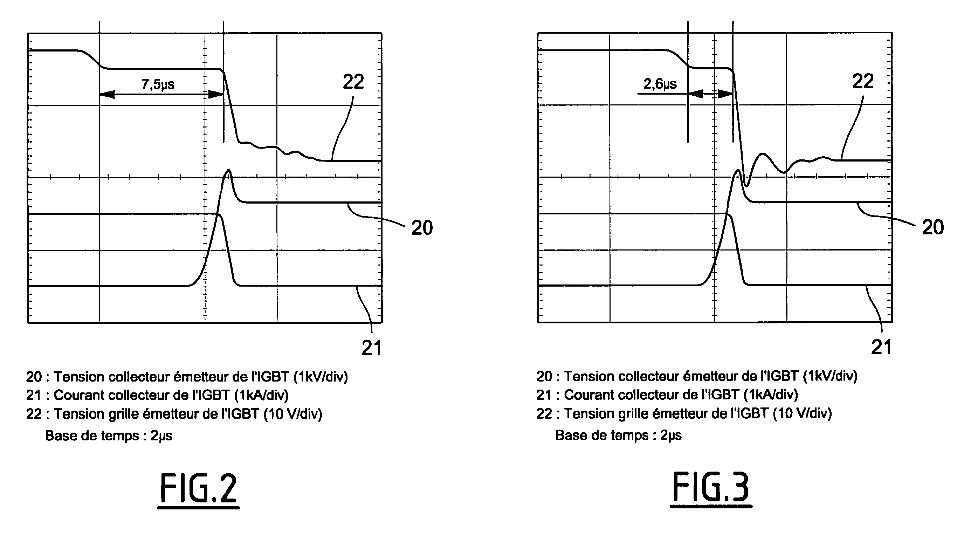

Les figures 2 et 3 permettent de comparer la valeur du délai d'ouverture lors de l'ouverture d'un IGBT avec et sans le circuit de la figure 1. Le transistor IGBT utilisé est un ST1500GXH24A commercialisé par la société Toshiba. Le courant commuté est de 2000 A et la tension au blocage vaut 2500 V (température = 25 °C). La valeur C de la capacité 8 est de 6.6 nF alors que Rg_off vaut 1 ohm (sans le circuit proposé, elle vaut 10 ohms).

Sans le circuit de l'invention (Rg_off=10 ohms), on retrouve la valeur typique du délai d'ouverture, c'est à dire environ 7,5 µs. La diminution de la valeur de Rg_off permet de diminuer cette valeur. Ici ce temps vaut 2,6 µs pour Rg_off=1ohm.

Les valeurs des dv/dt de la tension collecteur émetteur sont les suivantes :
- avec le circuit de l'invention : 2400 V/µs
- sans le circuit de l'invention : 2409,52 V/µs

L'ajout du condensateur 8 dans le circuit de l'invention permet donc de conserver les valeurs de dv/dt obtenues sans le circuit.

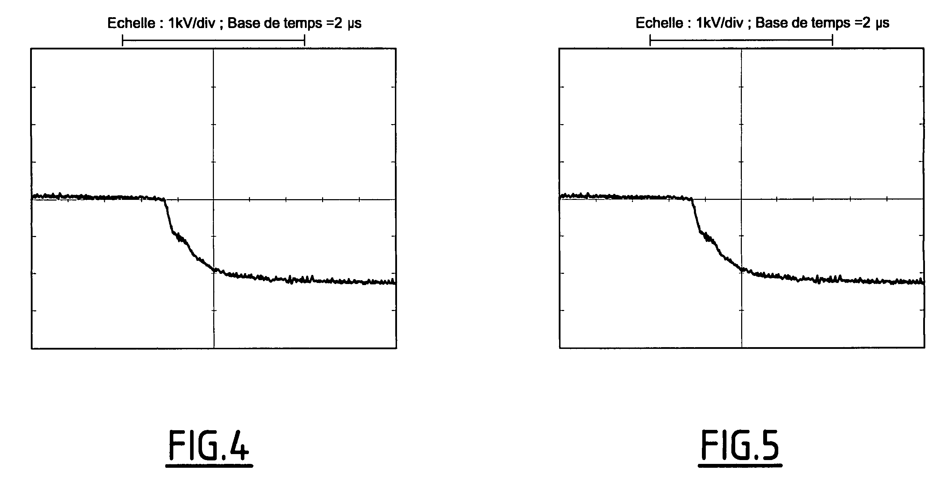

Les figure 4 et 5 permettent de comparer la tension collecteur émetteur lors d'une fermeture d'un IGBT avec et sans le circuit de la figure 1. Ces figures sensiblement identiques mettent en évidence le fait que le circuit de l'invention n'intervient pas lors de la fermeture.

La figure 6 montre l'équilibrage des tensions aux bornes de trois IGBTs connectés en série et équipés du circuit de l'invention (essai pour une tension de bus de 6000V et un courant commuté de 2000 A). Le déséquilibre de tension entre les trois IGBT ne dépasse pas 133 V.

La valeur de la résistance d'ouverture Rg_off 4 est comprise entre 0,5 et 5 ohms, de préférence comprise entre 0,7 et 2 ohms.

## Revendications

1. Circuit de commande d'un transistor IGBT (1), le transistor IGBT(1) étant propre à être connecté en série avec au moins un autre transistor IGBT, la grille du transistor IGBT (1) étant propre à être reliée à un circuit de commande de fermeture par l'intermédiaire d'une résistance de fermeture (3) et à un circuit de commande d'ouverture par l'intermédiaire d'une résistance d'ouverture (4), le circuit comprenant un condensateur (8) relié au collecteur et à la grille du transistor IGBT (1), et une diode (10) connectée en série avec le condensateur (8),
**caractérisé en ce qu'**il comprend en outre deux diodes Zener (12, 13) connectées tête-bêche entre l'émetteur du transistor IGBT (1) et le point commun (9) au condensateur (8) et à la diode (10), et **en ce que** la diode (10) est connectée en série entre le condensateur (8) et la grille du transistor IGBT (1).

2. Circuit de commande selon la revendication 1, dans lequel la diode (10) est connectée dans le sens passant du collecteur à la grille.

3. Circuit de commande selon la revendication 1 ou 2, comprenant en outre une résistance (6) en série avec le condensateur (8) et la diode (10).

4. Circuit de commande selon l'une quelconque des revendications précédentes, dans lequel la valeur de la capacité (C) du condensateur (8) est sensiblement égale à 6,6 nF.

5. Circuit de commutation électronique comprenant un transistor IGBT (1) propre à être connecté en série avec un transistor IGBT d'au moins un autre circuit de commutation, le circuit de commutation comprenant un circuit de commande de fermeture relié à la grille du transistor IGBT (1) par l'intermédiaire d'une résistance de fermeture (3), un circuit de commande d'ouverture relié à ladite grille par l'intermédiaire d'une résistance d'ouverture (4), et un circuit de commande du transistor IGBT (1),
**caractérisé en ce que** le circuit de commande du transistor IGBT(1) est conforme à l'une quelconque des revendications précédentes.

6. Circuit de commutation selon la revendication 5, dans lequel la valeur de la résistance d'ouverture (4) est choisie de sorte qu'un délai d'ouverture du transistor IGBT (1) lors de sa commutation soit inférieur à 3 µs.

7. Circuit de commutation selon la revendication 6, dans lequel la valeur de la résistance d'ouverture (4) est sensiblement égale à 1 ohm.

8. Equipement électronique de puissance comprenant une pluralité de circuits de commutation électronique, **caractérisé en ce que** chaque circuit de commutation est conforme à l'une quelconque des revendications 5 à 7, et **en ce que** les transistors IGBT de chacun des circuits de commutation sont connectés en série.

## Claims

1. Control circuit for an IGBT transistor (1), the IGBT transistor (1) being suitable to be connected in series with at least one other IGBT transistor, the gate of the IGBT transistor (1) being suitable to be linked to a turn-on control circuit by means of a turn-on resistor (3), and to a turn-off control circuit by means of a turn-off resistor (4), the circuit including a capacitor (8), linked to the collector and to the gate of the IGBT transistor (1), and a diode (10) connected in series with the capacitor (8),
**characterised in that** said control circuit includes, in addition, two Zener diodes (12, 13) connected head to tail between the emitter of the IGBT transistor (1) and the connecting point (9) common to the capacitor (8) and to the diode (10), and **in that** the diode (10) is connected in series between the capacitor (8) and the gate of the IGBT transistor (1).

2. Control circuit according to Claim 1, in which the diode (10) is connected in the direction passing from the collector to the gate.

3. Control circuit according to Claim 1 or 2, including, in addition, a resistor (6) in series with the capacitor (8) and the diode (10).

4. Control circuit according to any one of the preceding claims, in which the value of the capacitance (C) of the capacitor (8) is approximately equal to 6.6 nF.

5. Electronic-switching circuit including an IGBT transistor (1) which is suitable to be connected in series with an IGBT transistor of at least one other switching circuit, the switching circuit including a turn-on control circuit linked to the gate of the IGBT transistor (1) by means of a turn-on resistor (3), a turn-off control circuit linked to said gate by means of a turn-off resistor (4), and a control circuit of the IGBT transistor (1),
**characterised in that** the control circuit of the IGBT transistor (1) is in accordance with any one of the preceding claims.

6. Switching circuit according to Claim 5, in which the resistance of the turn-off resistor (4) is chosen so that a turn-off delay of the IGBT transistor (1) at the time of its switching is lower than 3 µs.

7. Switching circuit according to Claim 6, in which the resistance of the turn-off resistor (4) is approximately equal to 1 ohm.

8. Electronic power equipment including a plurality of electronic-switching circuits, **characterised in that** each switching circuit is in accordance with any one of Claims 5 to 7 and **in that** the IGBT transistors of each of the switching circuits are connected in series.

## Patentansprüche

1. Steuerschaltung für einen IGBT-Transistor (1), wobei der IGBT-Transistor (1) geeignet ist, in Reihenschaltung mit mindestens einem weiteren IGBT-Transistor verbunden zu werden, wobei sich das Gate des IGBT-Transistors (1) dazu eignet, über einen Schließwiderstand (3) an eine Schließsteuerschaltung und über einen Öffnungswiderstand (4) an eine Öffnungssteuerschaltung angeschlossen zu werden, wobei die Schaltung einen Kondensator (8), der an den Kollektor und das Gate des IGBT-Transistors (1) angeschlossen ist, und eine Diode (10) umfasst, die mit dem Kondensator (8) in Reihe geschaltet ist,
**dadurch gekennzeichnet, dass** die Steuerschaltung darüber hinaus zwei ZenerDioden (12, 13) umfasst, die antiparallel zwischen dem Emitter des IGBT-Transistors (1) und dem gemeinsamen Anschlusspunkt (9) des Kondenstors (8) und der Diode (10) angeschlossen sind, und dass die Diode (10) zwischen dem Kondensator (8) und dem Gate des IGBT-Transistors (1) in Reihe geschaltet ist.

2. Steuerschaltung nach Anspruch 1, bei der die Diode (10) in der vom Kollektor zum Gate verlaufenden Richtung angeschlossen ist.

3. Steuerschaltung nach Anspruch 1 oder 2, darüber hinaus einen mit dem Kondensator (8) und der Diode (10) in Reihe geschalteten Widerstand (6) umfassend.

4. Steuerschaltung nach einem der vorhergehenden Ansprüche, bei der der Wert der Kapazität (C) des Kondensators (8) im Wesentlichen gleich 6,6 nF ist.

5. Elektronischer Schaltkreis mit einem IGBT-Transistor (1), der geeignet ist, in Reihenschaltung mit einem IGBT-Transistor mindestens eines weiteren Schaltkreises verbunden zu werden, wobei der Schaltkreis eine Schließsteuerschaltung, die mittels eines Schließwiderstands (3) an das Gate des IGBT-Transistors (1) angeschlossen ist, eine Öffnungssteuerschaltung, die mittels eines Öffnungswiderstands (4) an das Gate angeschlossen ist, und eine Steuerschaltung des IGBT-Transistors (1) umfasst,
**dadurch gekennzeichnet, dass** die Steuerschaltung des IGBT-Transistors (1) einem der vorhergehenden Ansprüche entspricht.

6. Schaltkreis nach Anspruch 5, bei dem der Wert des Öffnungswiderstands (4) so gewählt ist, dass eine Öffnungsverzögerung des IGBT-Transistors (1) bei seiner Umschaltung unter 3 µs beträgt.

7. Schaltkreis nach Anspruch 6, bei dem der Wert des Öffnungswiderstands (4) im Wesentlichen 1 Ohm beträgt.

8. Elektronische Leistungsanlage mit mehreren elektronischen Schaltkreisen, **dadurch gekennzeichnet, dass** jeder Schaltkreis einem der Ansprüche 5 bis 7 entspricht, und dass die IGBT-Transistoren jedes der Schaltkreise in Reihe geschaltet sind.
